# EUROPÄISCHE PATENTSCHRIFT

(11) **EP 1 596 439 B1**
(45) Veröffentlichungstag und Bekanntmachung des Hinweises auf die Patenterteilung: **15.09.2010**
(21) Anmeldenummer: 05010035.3
(22) Anmeldetag: 09.05.2005
(51) Int. Cl.: H01L 31/107

(54) **Avalanche-Strahlungsdetektor**
Avalanche radiation detector
Photodétecteur à avalanche

(30) Priorität: 10.05.2004 DE 102004022948
(43) Veröffentlichungstag der Anmeldung: 16.11.2005
(73) Patentinhaber: Max-Planck-Gesellschaft zur Förderung der Wissenschaften e.V., 80539 München (DE)
(72) Erfinder: Lutz, Gerhard, 81739 München (DE); Richter, Rainer H., 81243 München (DE); Strüder, Lothar, 80803 München (DE)
(74) Vertreter: Beier, Ralph

(56) Entgegenhaltungen:
- US-A1- 2002 139 970
- LUTZ G ET AL: "THE AVALANCHE DRIFT DIODE: A NEW DETECTOR CONCEPT FOR SINGLE PHOTON DETECTION" NUCLEAR SCIENCE SYMPOSIUM CONFERENCE RECORD, 2004 IEEE ROME, ITALY 16-22 OCT. 2004, PISCATAWAY, NJ, USA,IEEE, 16. Oktober 2004 (2004-10-16), Seiten 21-24, XP010818787 ISBN: 0-7803-8700-7

## Beschreibung

Die Erfindung betrifft einen Avalanche-Strahlungsdetektor gemäß dem Oberbegriff des Anspruchs 1.

Ein derartiger Strahlungsdetektor ist beispielsweise aus Curt Rint: "Handbuch für Hochfrequenz- und Elektrotechniker", 12. Auflage, Hüthig und Pflaum Verlag München/Heidelberg, Seite 478 bekannt. Hierbei befindet sich in einem planaren Halbleitersubstrat auf einer Seite ein Avalanche-Bereich und auf der gegenüberliegenden Seite ein Strahlungseintrittsfenster für die zu detektierende Strahlung, die in dem Halbleitersubstrat freie Ladungsträger erzeugt. Die von der zu detektierenden Strahlung erzeugten freien Ladungsträger werden in dem Avalanche-Bereich durch das dortige elektrische Feld beschleunigt und erzeugen lawinenartig neue Ladungsträger, was als Stromfluss detektierbar ist. Die elektrische Feldstärke in dem Avalanche-Bereich wird hierbei durch eine Steuerelektrode eingestellt, die auf der dem Avalanche-Bereich gegenüber liegenden Seite des Avalanche-Strahlungsdetektors angeordnet ist.

Nachteilig an dieser Anordnung der Steuerelektrode ist die Tatsache, dass mit zunehmender Dicke des Avalanche-Strahlungsdetektors und einer entsprechenden Vergrößerung des Abstandes zwischen der Steuerelektrode und dem gegenüberliegenden Avalanche-Bereich auch entsprechende große Steuerspannungen eingesetzt werden müssen, um die elektrische Feldstärke in dem Avalanche-Bereich auf den gewünschten Wert einzustellen.

Eine genaue Einstellung der elektrischen Feldstärke in dem Avalanche-Bereich ist jedoch wichtig, da bei einer zu geringen Feldstärke in dem Avalanche-Bereich die Empfindlichkeit leidet, wohingegen das Rauschen mit der elektrischen Feldstärke in dem Avalanche-Bereich zunimmt, da auch stochastisch generierte Ladungsträger zu einer Lawinenbildung führen können.

Die maximale Dicke des bekannten Avalanche-Strahlungsdetektors ist also durch die maximal zulässige Steuerspannung an der Steuerelektrode begrenzt. Zur Erreichung einer möglichst großen Empfindlichkeit ist es jedoch wünschenswert, dass der Avalanche-Strahlungsdetektor einen möglichst großvolumigen photosensitiven Bereich aufweist, was jedoch aufgrund der vorstehend erwähnten Dickenbeschränkung nur begrenzt möglich ist. Eine Ausdehnung des photosensitiven Bereichs in lateraler Richtung ist dagegen schwierig, da sich großflächige Avalanche-Bereiche wegen der erforderlichen Strukturgenauigkeit der pn-Übergänge fertigungstechnisch kaum herstellen lassen.

Aus US 2002/139970 A1 ist ein Avalanche-Strahlungsdetektor bekannt, bei dem ein Avalanche-Bereich mit einem p⁺-dotierten Bereich in die Oberseite des Halbleitersubstrats eingelassen ist. Der p⁺-dotierte Bereich des Avalanche-Bereichs ist hierbei also nicht in dem Halbleitersubstrat vergraben. Die Ansteuerung des p⁺-dotierten Bereichs des Avalanche-Bereichs erfolgt hierbei mittels des "Punch-through-Effekts" durch eine ringförmig umgebende Steuerelektrode. Nachteilig daran ist, dass ein sehr stark negatives elektrisches Potenzial an die umgebende Steuerelektrode angelegt werden muss, um den p⁺-dotierten Bereich des Avalanche-Bereichs anzusteuern. Dadurch wird wiederum eine Potenzialbarriere in dem Halbleitersubstrat erzeugt, welche das Auslesen der Signalelektronen erschwert oder gar verhindert. Aus diesem Grund muss die ringförmige Steuerelektrode bei diesem Avalanche-Strahlungsdetektor in der Mitte eine große Öffnung aufweisen, durch die strahlungsgenerierte Signalelektronen zu der Ausleseanode gelangen können. Bei diesem Avalanche-Strahlungsdetektor sind der Miniaturisierung also Grenzen gesetzt, da die ringförmige Steuerelektrode in der Mitte stets ein Loch mit einer bestimmten Größe aufweisen muss.

Der Erfindung liegt deshalb die Aufgabe zugrunde, einen verbesserten Avalanche-Strahlungsdetektor zu schaffen.

Diese Aufgabe wird, ausgehend von dem vorstehend beschriebenen bekannten Avalanche-Strahlungsdetektor gemäß dem Oberbegriff des Anspruchs 1, durch die kennzeichnenden Merkmale des Anspruchs 1 gelöst.

Die Erfindung umfasst die allgemeine technische Lehre, die Steuerelektrode zur Einstellung der elektrischen Feldstärke in dem Avalanche-Bereich nicht auf der dem Avalanche-Bereich gegenüberliegenden Seite des Avalanche-Strahlungsdetektors anzuordnen, sondern auf derselben Seite wie der Avalanche-Bereich. Dies bietet den Vorteil, dass aufgrund der räumlichen Nähe der Steuerelektrode zu dem Avalanche-Bereich geringere Steuerspannungen ausreichen, um die elektrische Feldstärke in dem Avalanche-Bereich auf den gewünschten Wert einzustellen. Darüber hinaus bietet diese Anordnung der Steuerelektrode den Vorteil, dass die erforderlichen Steuerspannungen zur Einstellung der elektrischen Feldstärke in dem Avalanche-Bereich durch die Dicke des Avalanche-Strahlungs-detektors nicht beeinflusst werden. Der erfindungsgemäße Avalanche-Strahlungsdetektor kann deshalb wesentlich dicker sein, als der eingangs beschriebene bekannte Avalanche-Strahlungsdetektor, was aufgrund des vergrößerten photosensitiven Bereichs zu einer entsprechend größeren Empfindlichkeit führt. Beispielsweise kann die Dicke des erfindungsgemäßen Avalanche-Strahlungsdetektors im Bereich zwischen 30 µm und 1 mm liegen, wobei beliebige Zwischenwerte innerhalb dieses Wertebereichs möglich sind.

Vorzugsweise umgibt die Steuerelektrode den Avalanche-Bereich ringförmig, wobei der Begriff einer ringförmigen Anordnung der Steuerelektrode nicht auf eine kreisförmige oder sonstwie runde Gestaltung der Steuerelektrode beschränkt ist, sondern auch eine eckige Steuerelektrode umfasst, die den Avalanche-Bereich einschließt.

Weiterhin wird in dem Halbleitersubstrat vorzugsweise ein elektrisches Driftfeld erzeugt, das die von der zu detektierenden Strahlung generierten Ladungsträger innerhalb des Halbleitersubstrats zu dem Avalanche-Bereich bewegt. Auf diese Weise kann der photosensitive Bereich des Halbleitersubstrats wesentlich größer als der Avalanche-Bereich sein, wobei das Driftfeld sicher stellt, dass alle innerhalb des photosensitiven Bereichs erzeugten Ladungsträger zu dem Avalanche-Bereich gelangen und dort zur Lawinenbildung beitragen. Dies ermöglicht vorteilhaft einen großvolumigen photosensitiven Bereich, was zu einer erhöhten Empfindlichkeit des erfindungsgemäßen Avalanche-Strahlungsdetektors beiträgt.

Die Erzeugung des Driftfeldes zur Bewegung der Ladungsträger zu dem Avalanche-Bereich erfolgt vorzugsweise durch Elektrodenanordnungen, wie sie bei herkömmlichen Driftdetektoren bekannt sind. Beispielsweise können hierzu mehrere Sammelelektroden vorgesehen sein, die den Avalanche-Bereich umgeben und das Driftfeld erzeugen, wobei die Sammelelektroden vorzugsweise ringförmig und im Wesentlichen konzentrisch angeordnet sind.

Vorzugsweise ist die Steuerelektrode bei dem erfindungsgemäβen Avalanche-Strahlungsdetektor entsprechend einem ersten Dotierungstyp dotiert, während das Halbleitersubstrat entsprechend einem entgegengesetzten zweiten Dotierungstyp dotiert ist. Bei dem ersten Dotierungstyp kann es sich beispielsweise um eine p-Dotierung handeln, während der zweite Dotierungstyp aus einer n-Dotierung besteht. Es ist jedoch alternativ auch möglich, dass der erste Dotierungstyp eine n-Dotierung ist, während der zweite Dotierungstyp eine p-Dotierung ist.

Bei dem erfindungsgemäßen Avalanche-Strahlungsdetektor tritt die zu detektierende Strahlung durch ein Strahlungseintrittsfenster in den Strahlungsdetektor ein, wobei das Strahlungseintrittsfenster vorzugsweise an der Rückseite des Halbleitersubstrats angeordnet ist, also auf der dem Avalanche-Bereich gegenüberliegenden Seite. Diese Anordnung des Strahlungseintrittsfensters bietet den Vorteil, dass die zu detektierende Strahlung nicht durch die lichtundurchlässigen Strukturen (z.B. Verbindungsleitungen) auf der Seite des Avalanche-Bereichs abgeschattet wird.

Vorzugsweise ist das Strahlungseintrittsfenster für die zu detektierende Strahlung wesentlich großflächiger als der Avalanche-Bereich. Dies bietet den Vorteil, dass wesentlich mehr Strahlung detektiert werden kann als unmittelbar auf den Avalanche-Bereich fällt, wobei die durch die eingefallene Strahlung außerhalb des Avalanche-Bereichs generierten Ladungsträger vorzugsweise durch das vorstehend erwähnte Driftfeld zu dem Avalanche-Bereich geleitet werden, um dort zu der Lawinenbildung beizutragen.

Weiterhin weist der Avalanche-Bereich einen in dem Halbleitersubstrat vergrabenen und entsprechend dem ersten Dotierungstyp dotierten Halbleiterbereich auf, wobei der vergrabene Halbleiterbereich von der Steuerelektrode ansteuerbar ist. Dieser vergrabene Halbleiterbereich bestimmt die elektrische Feldstärke in dem Avalanche-Bereich und damit den Multiplikationsfaktor des erfindungsgemäßen Avalanche-Strahlungsdetektors.

In einer Variante der Erfindung variiert die Dotierung des vergrabenen Halbleiterbereichs in lateraler Richtung hinsichtlich der Dotierungsstärke und/oder hinsichtlich der Tiefenausdehnung. Auf diese Weise kann die elektrische Feldstärke in dem Avalanche-Bereich in lateraler Richtung beeinflusst werden, um eine möglichst gleichförmige Feldstärkeverteilung innerhalb des Avalanche-Bereichs zu erzielen.

Der vergrabene Halbleiter-Bereich ist vorzugsweise vollständig verarmt, um zu verhindern, dass die in dem photosensitiven Bereich durch Strahlungseinwirkung generierten Ladungsträger in dem vergrabenen Halbleiterbereich rekombinieren, was eine Detektion verhindern würde. Außerhalb des Avalanche-Bereichs ist der vergrabene Halbleiterbereich dagegen vorzugsweise nur teilweise verarmt, damit der vergrabene Halbleiterbereich dort eine Barriere für die durch Strahlungseinwirkung generierten Ladungsträger bildet.

Der Avalanche-Bereich weist vorzugsweise eine Ausleseelektrode auf, die entsprechend dem zweiten Dotierungstyp dotiert ist, wobei es sich vorzugsweise um eine n-Dotierung handelt.

Vorzugsweise ist die Ausleseelektrode des Avalanche-Bereichs in einen niedriger dotierten Halbleiterbereich desselben Dotierungstyps eingebettet. Dies bietet den Vorteil, dass sich die Durchbruchsfeldstärke im oberflächennahen Bereich verringert.

Die Dotierung der Ausleseelektrode und/oder des Halbleiterbereichs in den die Ausleseelektrode eingebettet ist, kann hierbei in lateraler Richtung hinsichtlich der Dotierungsstärke und/oder hinsichtlich der Tiefenausdehnung variieren. Dies ermöglicht innerhalb des Avalanche-Bereichs ebenfalls eine gleichmäßige Feldstärkeverteilung in lateraler Richtung.

Zur lateralen Variation der Dotierung besteht die Möglichkeit, dass sich die Ausleseelektrode oder der Halbleiterbereich, in den die Ausleseelektrode eingebettet ist, einerseits und der vergrabene Halbleiterbereich andererseits in der Tiefe teilweise überlappen, wobei sich deren gegenteilige Dotierung mindestens teilweise kompensiert.

Weiterhin ist zu erwähnen, dass sich der vergrabene Halbleiterbereich in dem Halbleitersubstrat in lateraler Richtung bis unter die Steuerelektrode erstrecken kann. Dadurch wird erreicht, dass der Abstand zwischen der Steuerelektrode und der Ausleseelektrode vergrößert werden kann.

Die Steuerelektrode ist hierbei direkt mit dem vergrabenen Halbleiterbereich leitend verbunden.

An der Rückseite des Halbleitersubstrats und damit auf der dem Avalanche-Bereich gegenüberliegenden Seite ist vorzugsweise eine Rückelektrode angeordnet, um das Halbleitersubstrat von Ladungsträgern zu verarmen, wobei die Rückelektrode vorzugsweise entsprechend dem ersten Dotierungstyp dotiert ist und damit in der Regel eine p-Dotierung aufweist. Die Verarmung des Halbleitersubstrats im photosensitiven Bereich ist wichtig, da ansonsten vorhandene freie Ladungsträger Fehldetektionen auslösen könnten.

Weiterhin ist zu erwähnen, dass in dem Halbleitersubstrat vorzugsweise ein elektrisches Feld mit einer Potentialbarriere besteht, wobei die Potentialbarriere eine Emission von Löchern aus der Steuerelektrode und/oder aus der Rückelektrode zu der jeweils gegenüberliegenden Seite des Halbleitersubstrats verhindert.

Zur Erzeugung der Potentialbarriere können die Steuerelektrode und die Rückelektrode gegenüber der Ausleseelektrode elektrisch negativ vorgespannt sein.

Hierbei besteht zwischen der Steuerelektrode und der Rückelektrode vorzugsweise ein Potentialunterschied, der so gering ist, dass sich die Potentialbarriere zwischen der Steuerelektrode und der Rückelektrode befindet.

Ferner ist zu erwähnen, dass das Halbleitersubstrat in der Praxis wesentlich schwächer dotiert ist, als der vergrabene Halbleiterbereich, die Ausleseelektrode, die Rückelektrode und/oder die Steuerelektrode.

Weiterhin ist noch zu erwähnen, dass das Halbleitersubstrat, der vergrabene Halbleiterbereich, die Ausleseelektrode, die Rückelektrode und/oder die Steuerelektrode mindestens teilweise aus Silizium oder Germanium bestehen können.

Schließlich besteht auch die Möglichkeit, mehrere erfindungsgemäße Avalanche-Strahlungsdetektoren in einer Detektoranordnung matrixförmig anzuordnen.

Andere vorteilhafte Weiterbildungen der Erfindung sind in den Unteransprüchen gekennzeichnet oder werden nachstehend zusammen mit der Beschreibung der bevorzugten Ausführungsbeispiele anhand der Figuren näher erläutert. Es zeigen:
- Figur 1A: eine Draufsicht auf einen nicht erfindungsgemäßen Avalanche-Strahlungsdetektor,
- Figur 1B: eine Querschnittsansicht des Avalanche-Strahlungs- detektors aus Figur 1A,
- Figur 2: eine Querschnittsansicht eines Ausführungsbeispiels eines erfindungsgemäßen Avalanche- Strahlungsdetektors mit einem vergrabenen Halblei- terbereich, der in lateraler Richtung bis unter die Steuerelektrode gezogen ist,
- Figur 3: ein weiteres alternatives Ausführungsbeispiel eines erfindungsgemäßen Avalanche-Strahlungsdetektors, bei
- Figur 4: dem die Dotierung des vergrabenen Halbleiterbereichs in lateraler Richtung variiert, ein weiteres alternatives Ausführungsbeispiel eines erfindungsgemäßen Avalanche-Strahlungsdetektors, bei dem die Ausleseelektrode in einen Halbleiterbereich eingebettet ist, dessen Dotierung in lateraler Rich- tung variiert,
- Figur 5: ein weiteres Ausführungsbeispiel eines erfindungsge- mäßen Avalanche-Strahlungsdetektors, bei dem die Do- tierung des vergrabenen Halbleiterbereichs in late- raler Richtung variiert,
- Figur 6: eine Querschnittsansicht eines weiteren Ausführungs- beispiels eines erfindungsgemäßen Avalanche-Strah- lungsdetektors mit mehreren ringförmigen und konzen- trisch angeordneten Steuer- bzw. Sammelelektroden sowie
- Figur 7: eine Querschnittsansicht eines weiteren Ausführungs- beispiels eines erfindungsgemäßen Avalanche- Strahlungsdetektors mit einer zusätzlichen n-Implan- tation.

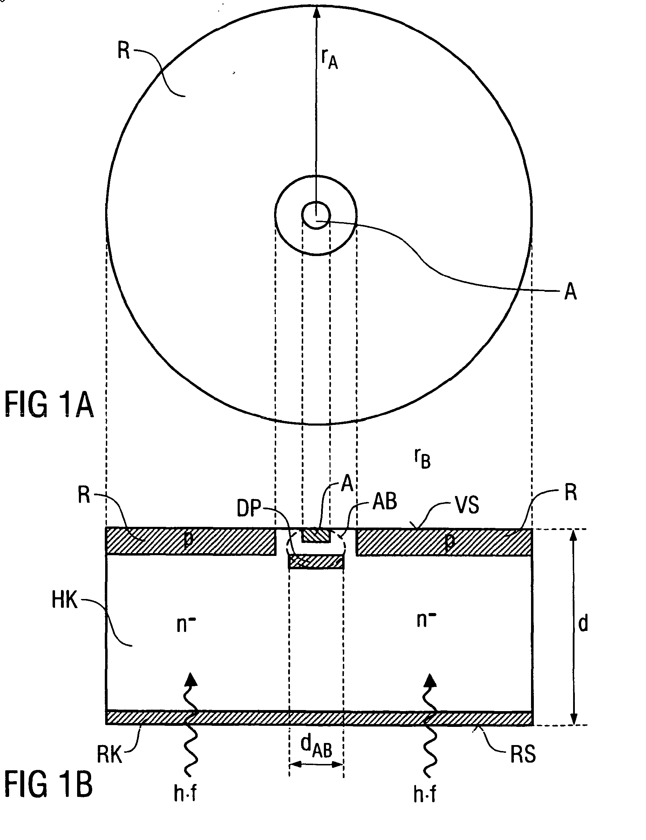

Der in den Figuren 1A und 1B dargestellte Avalanche-Strahlungsdetektor weist einen kreisscheibenförmigen, schwach n-dotierten Halbleiterkörper HK aus Silizium auf, wobei der Halbleiterkörper HK einen Radius r_{A} im Zentimeterbereich und eine Dicke d im Bereich zwischen 30 µm und 1 mm aufweisen kann.

An seiner Rückseite RS weist der Halbleiterköper HK eine p-dotierte Rückelektrode RK auf, um den Halbleiterkörper HK von Ladungsträgern zu verarmen.

Darüber hinaus bildet die Rückseite RS des Halbleiterkörpers HK ein Strahlungseintrittsfenster, über das die zu detektierende Strahlung in den Halbleiterkörper HK eintritt und dort Ladungsträger generiert.

Auf seiner Vorderseite VS weist der Halbleiterkörper HK eine p-dotierte ringförmige Steuerelektrode R auf, die einen Avalanche-Bereich AB ringförmig umgibt, wobei der Avalanche-Bereich an der Vorderseite VS oberflächennah in dem Halbleiterkörper HK angeordnet ist. Der Avalanche-Bereich AB kann einen Durchmesser d_{AB} im Mikrometerbereich aufweisen, wobei sich ein Wert von d_{AB}=10 µm als vorteilhaft erwiesen hat. Die geringen Abmessungen des Avalanche-Bereichs AB bei dem Avalanche-Strahlungsdetektor ermöglichen im Vergleich zu gröβeren Avalanche-Strukturen vorteilhaft eine kostengünstige Fertigung.

Der Avalanche-Bereich AB weist hierbei einen vergrabenen p-dotierten Halbleiterbereich DP und eine n-dotierte Ausleseelektrode A auf, wobei der vergrabene Halbleiterbereich DP durch die Steuerelektrode R angesteuert wird.

Darüber hinaus erzeugt die Steuerelektrode R in dem Halbleiterkörper HK ein elektrisches Driftfeld, das die in dem Halbleiterkörper HK durch Strahlungseinwirkung generierten Elektroden zu dem Avalanche-Bereich AB leitet, wo die Signalelektronen zu einer Lawinenbildung führen, die über die Ausleseelektrode A detektiert wird. Das Driftfeld ermöglicht es, dass das Strahlungseintrittsfenster und der photosensitive Bereich in dem Halbleiterkörper HK wesentlich größer sind als der Avalanche-Bereich AB. Der Avalanche-Strahlungsdetektor vereinigt also den Vorteil einer großen Empfindlichkeit aufgrund des großen Strahlungseintrittsfensters und des großvolumigen photosensitiven Bereichs mit dem Vorteil einer kostengünstigen, herkömmlichen Herstellung, da der Avalanche-Bereich AB relativ klein ist.

Zum Betrieb dieses Avalanche-Strahlungsdetektors werden an die Ausleseelektrode A, die Steuerelektrode R und die Rückelektrode RK elektrische Spannungen angelegt, so dass der Halbleiterkörper HK einschließlich des vergrabenen Halbleiterbereichs DP vollständig von Ladungsträgern verarmt ist und eine Potentialbarriere in dem Halbleiterkörper entsteht, die eine Emission von Löchern aus der p-dotierten Steuerelektrode R oder aus der ebenfalls p-dotierten Rückelektrode RK zur gegenüberliegenden Seite des Halbleiterkörpers HK verhindert.

Dieser Zustand wird erreicht, wenn sowohl die Rückelektrode RK als auch die Steuerelektrode R gegenüber der Ausleseelektrode A negativ vorgespannt werden, wobei der Potentialunterschied zwischen der Steuerelektrode R und der Rückelektrode RK so begrenzt wird, dass zwischen ihnen ein Potentialmaximum erhalten bleibt, das als Barriere für die Löcheremission wirkt.

Die in dem verarmten Halbleiterkörper HK erzeugten Signalelektronen werden dann über dieses Potentialmaximum zu dem Avalanche-Bereich AB geführt.

Die elektrische Feldstärke in dem Avalanche-Bereich AB wird durch Dotierungsstärke und Tiefe des vergrabenen, dotierten Halbleiterbereichs DP bestimmt und kann zusätzlich durch die zwischen der Ausleseelektrode A und der Steuerelektrode R angelegte Spannung variiert werden.

Auch das Potential an der Rückelektrode RK beeinflusst die elektrische Feldstärke in dem Avalanche-Bereich AB, wobei der Einfluss der Rückelektrode RK jedoch aufgrund des größeren Abstandes zu dem Avalanche-Bereich AB geringer ist, als der Einfluss der unmittelbar benachbarten Steuerelektrode R.

Dieses Ausführungsbeispiel ermöglicht vorteilhaft ein großes Strahlungseintrittsfenster und einen großvolumigen photosensitiven Bereich bei einem relativ kleinen Avalanche-Bereich. Das große Strahlungseintrittsfenster und der großvolumige photosensitive Bereich tragen hierbei zu einer großen Empfindlichkeit des Avalanche-Strahlungsdetektors bei, während der relativ kleine Avalanche-Bereich den Fertigungsaufwand in Grenzen hält, da sich großflächige Avalanche-Strukturen nur schwer herstellen lassen.

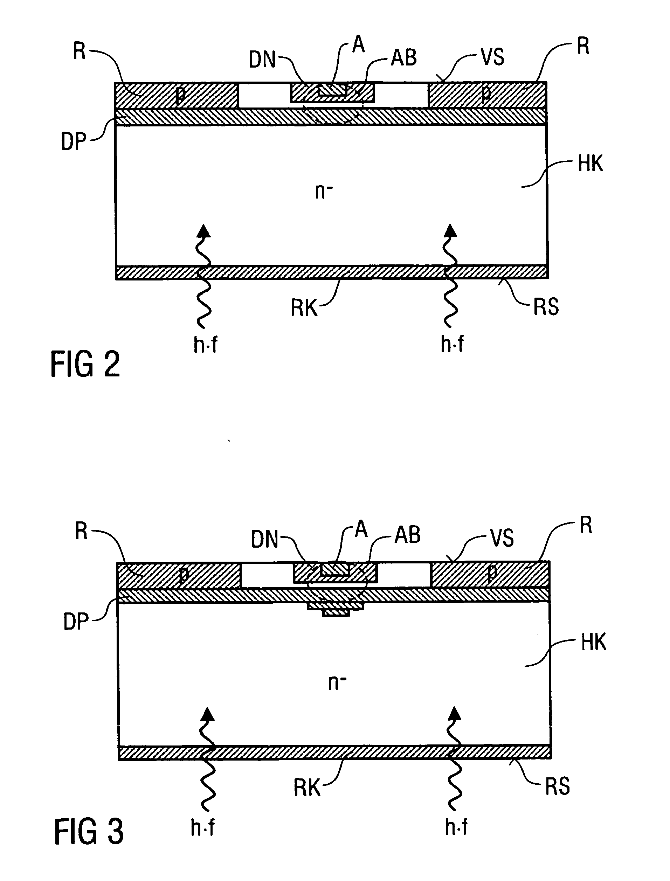

Das in Figur 2 dargestellte Ausführungsbeispiel eines erfindungsgemäßen Avalanche-Strahlungsdetektors stimmt weitgehend mit dem vorstehend beschriebenen und in den Figuren 1A und 1B dargestellten Ausführungsbeispiel überein, so dass zur Vermeidung von Wiederholungen weitgehend auf die vorstehende Beschreibung zu den Figuren 1A und 1B verwiesen wird, wobei im Folgenden für entsprechende Bereiche dieselben Bezugszeichen verwendet werden.

Eine Besonderheit dieses Ausführungsbeispiels besteht darin, dass die stark n-dotierte Ausleseelektrode A hierbei in einen schwächer n-dotierten Halbleiterbereich DN eingebettet ist.

Darüber hinaus ist der vergrabene, p-dotierte Halbleiterbereich DP in lateraler Richtung nach außen bis zu der Steuerelektrode R durchgezogen und mit dieser verbunden.

Zum einen wird durch diese Anordnung erreicht, dass der Abstand zwischen der Steuerelektrode R und der Ausleseelektrode A vergrößert werden kann.

Zum anderen wird auf diese Weise die Durchbruchsfeldstärke in dem Avalanche-Bereich AB oberflächennah herabgesetzt.

Der vergrabene, p-dotierte Halbleiterbereich DP ist hierbei jedoch nicht über seinen gesamten Bereich verarmt, sondern nur unterhalb des Avalanche-Bereichs AB. Das negative Potential der Steuerelektrode R wird hierbei also nicht mehr über die ringförmige Steuerelektrode R selbst an den Avalanche-Bereich AB herangeführt, sondern über den vergrabenen, p-dotierten Halbleiterbereich DP. Auf diese Weise werden die in dem Halbleiterkörper HK durch Strahlungseinwirkung entstandenen Signalelektronen in Richtung des Avalanche-Bereichs AB fokussiert.

Das in Figur 3 dargestellte Ausführungsbeispiel eines erfindungsgemäßen Avalanche-Strahlungsdetektors stimmt ebenfalls weitgehend mit dem vorstehend beschriebenen und in den Figuren 1A und 1B dargestellten Ausführungsbeispiel überein, so dass zur Vermeidung von Wiederholungen weitgehend auf die vorstehende Beschreibung verwiesen wird, wobei für entsprechende Bereiche dieselben Bezugszeichen verwendet werden.

Dieses Ausführungsbeispiel beruht auf der Erkenntnis, dass in dem Avalanche-Bereich AB eine möglichst gleichförmige Ausbildung des elektrischen Feldes wünschenswert ist, was bei den vorangehenden Ausführungsbeispielen nicht optimal umgesetzt wird. So sind bei dem vorangegangenen Ausführungsbeispiel am Rand des Avalanche-Bereichs AB höhere Feldstärke zu erwarten als in der Mitte des Avalanche-Bereichs AB. Auch wenn die in dem Halbleiterkörper HK durch Strahlungseinwirkung generierten Signalelektronen ausschließlich mittig durch den Avalanche-Bereich AB laufen, ist die ungleichförmige Feldstärke in dem Avalanche-Bereich AB bei den vorangegangenen Ausführungsbeispielen nachteilig.

Wenn die vorangegangenen Ausführungsbeispiele beispielsweise im Proportionalmodus betrieben werden, so sind die maximale elektrische Feldstärke und damit auch der Ladungsmultiplikationsfaktor durch die Verhältnisse am Rand des Avalanche-Bereichs AB begrenzt, da dort ein Lawinendurchbruch verhindert werden muss.

Will man den Avalanche-Strahlungsdetektor dagegen im sogenannten Geiger-Modus betreiben, in dem eine Löschung der Ladungsträgerlawine durch Verringerung der angelegten Spannung erreicht wird, so ist eine wesentlich stärkere Verringerung der Spannung erforderlich, weil die ursprünglich im Zentralbereich des Avalanche-Bereichs AB ausgelöste Ladungsträgerlawine sich in den äußeren Avalanche-Bereich AB ausbreitet und auch dort zum Stillstand kommen muss.

Diese Probleme werden bei dem Ausführungsbeispiel gemäß Figur 3 dadurch gelöst, dass die Dotierung des vergrabenen, p-dotierten Halbleiterbereichs unterhalb des Avalanche-Bereichs AB in lateraler Richtung variiert. Diese Dotierungsvariation kann beispielsweise durch strukturierte Implantationen erreicht werden, wobei nicht nur die geometrische Ausdehnung, sondern auch Dosis und Energie (Tiefe) verändert werden können.

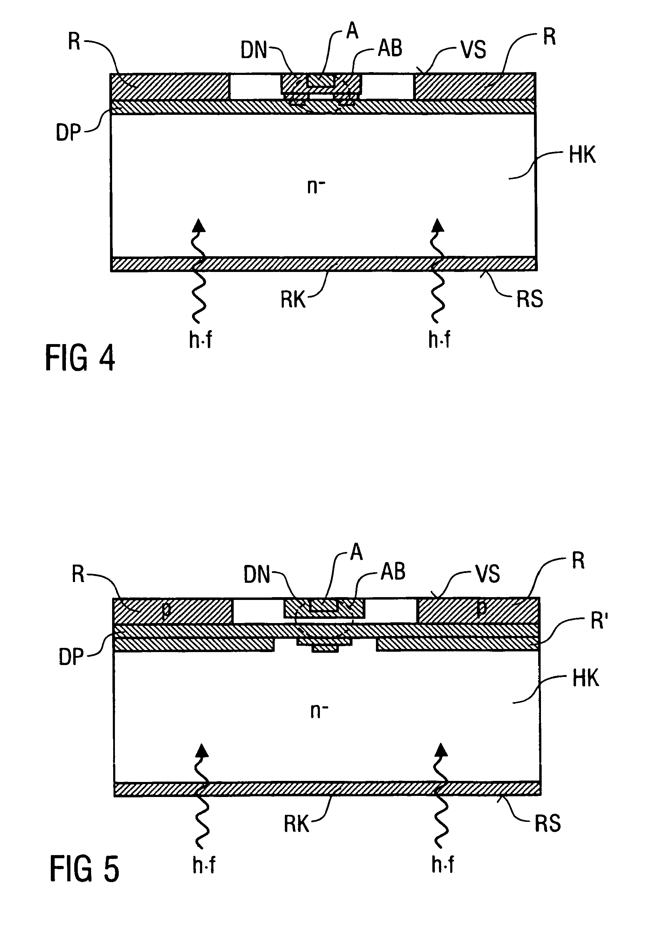

Das in Figur 4 dargestellte Ausführungsbeispiel stimmt ebenfalls weitgehend mit den vorstehend beschriebenen Ausführungsbeispielen überein, so dass zur Vermeidung von Wiederholungen weitgehend auf die vorstehende Beschreibung verwiesen wird, wobei für entsprechende Bereiche dieselben Bezugszeichen verwendet werden.

Die Gleichförmigkeit der elektrischen Feldstärke innerhalb des Avalanche-Bereichs AB wird hierbei jedoch nicht durch eine laterale Dotierungsvariation innerhalb des vergrabenen, p-dotierten Halbleiterbereichs DP erreicht, sondern durch eine Dotierungsvariation in dem n-dotierten Halbleiterbereich DN, in den die Ausleseelektrode A eingebettet ist. Die Verringerung der elektrischen Feldstärke am Rand des Avalanche-Bereichs AB erfolgt hierbei durch teilweise Kompensation mittels einer Strukturierung der tiefen n-Dotierung des Halbleiterbereichs DN, deren Ausläufer mit dem vergrabenen, p-dotierten Halbleiterbereich DP überlappen.

Das in Figur 5 dargestellte Ausführungsbeispiel eines erfindungsgemäßen Avalanche-Strahlungsdetektors stimmt wieder weitgehend mit den vorstehend beschriebenen Ausführungsbeispielen überein, so dass zur Vermeidung von Wiederholungen weitgehend auf die vorstehende Beschreibung verwiesen wird, wobei für entsprechende Bereiche dieselben Bezugszeichen verwendet werden.

Zur Verbesserung der Fokussierungseigenschaften der Signalelektronen ist hierbei zusätzlich eine ringförmige, vergrabene, p-dotierte Ringelektrode R' vorgesehen, die unterhalb des vergrabenen, p-dotierten Halbleiterbereichs DP angeordnet ist. Dadurch wird das elektrische Potential der Steuerelektrode R noch näher an den Avalanche-Bereich AB herangebracht, wodurch die Steuerwirkung der Steuerelektrode R auf den Avalanche-Bereich AB vergrößert wird. Die Anforderungen an die genaue Einhaltung der erforderlichen Dotierung des vergrabenen, p-dotierten Halbleiterbereichs DP werden dadurch geringer, da Abweichungen leichter durch Veränderungen des an die Steuerelektrode R angelegten elektrischen Potentials kompensiert werden können. Im Geiger-Modus wird die für das Löschen der Ladungsträgerlawine erforderliche Spannungsreduktion verringert.

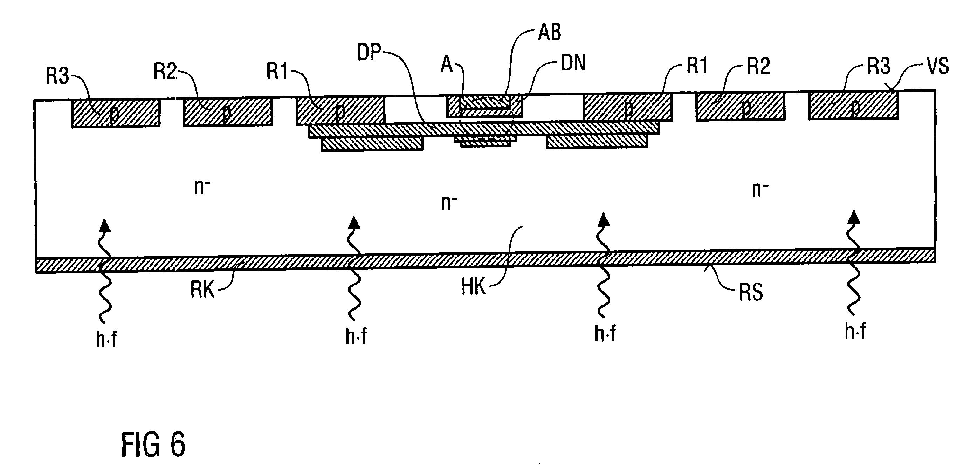

Das in Figur 6 dargestellte Ausführungsbeispiel eines erfindungsgemäßen Avalanche-Strahlungsdetektors stimmt ebenfalls weitgehend mit den vorstehend beschriebenen Ausführungsbeispielen überein, so dass zur Vermeidung von Wiederholungen weitgehend auf die vorstehende Beschreibung verwiesen wird, wobei für entsprechende Bereiche dieselben Bezugszeichen verwendet werden.

Eine Besonderheit dieses Ausführungsbeispiels besteht darin, dass der Avalanche-Bereich AB hierbei von mehreren konzentrischen Ringelektroden R1, R2, R3 umgeben ist, die in dem Halbleiterkörper HK ein Driftfeld erzeugen, durch das die in dem Halbleiterkörper HK durch Strahlungseinwirkung entstandenen Signalelektroden zu dem Avalanche-Bereich AB geführt werden. Die einzelnen Ringelektroden R1, R2, R3 liegen hierzu auf einem unterschiedlichen, nach außen abfallenden elektrischen Potential.

Der Avalanche-Strahlungsdetektor weist dadurch bei kleiner Ausdehnung des Avalanche-Bereichs AB eine sehr große Sammelfläche für die zu detektierende Strahlung auf, wobei die Zeitauflösung bei der Detektion durch die maximale Driftzeit bestimmt wird.

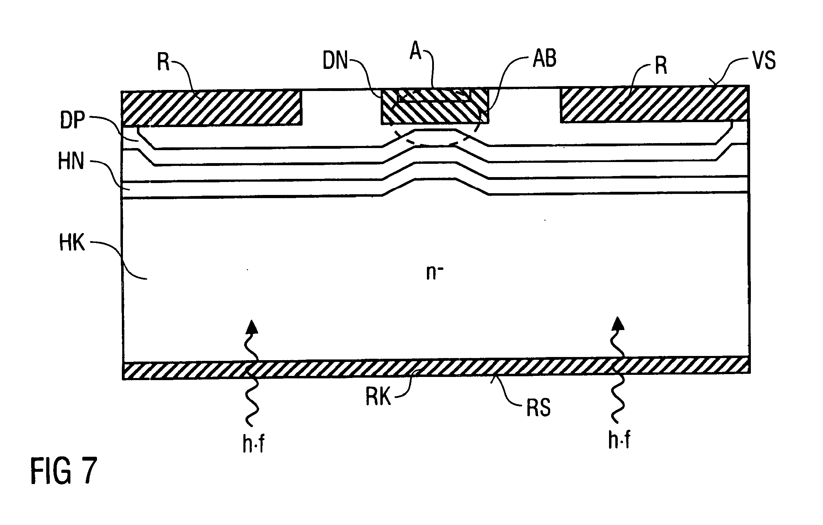

Das in Figur 7 dargestellte Ausführungsbeispiel eines erfindungsgemäßen Avalanche-Strahlungsdetektors stimmt weitgehend mit den vorstehend beschriebenen Ausführungsbeispielen überein, so dass zur Vermeidung von Wiederholungen weitgehend auf die vorstehende Beschreibung verwiesen wird, wobei im Folgenden für entsprechende Bereiche dieselben Bezugszeichen verwendet werden.

Gegenüber den vorher gezeigten Ausführungsbeispielen ist der vergrabene p-dotierte Halbleiterbereich DP über den größten Teil der Struktur in weiterem Abstand von der Vorderseite VS angeordnet. In dem Avalanche-Bereich AB ist der vergrabene p-dotierte Halbleiterbereich DP aber wieder näher an die Vorderseite VS herangeführt. Damit wird erreicht, daß die Hochfeldregion auf diesen Nahbereich beschränkt wird. Gleichzeitig wird eine vollständige Verarmung des vergrabenen p-dotierten Halbleiterbereichs DP außerhalb dieses Nahbereichs verhindert und das Potential der Steuerelektrode R nahe an den Avalanche-Bereich AB durchgestellt.

Figur 7 enthält zusätzlich zu den vorher gezeigten Beispielen ein zusätzliche vergrabene n-Implantation HN, die die Emission von Löchern (p) aus der Steuerelektrode R zu der auf der Rückseite RS angeordneten Rückelektrode RK hin verhindert. Auch die n-Implantation HN kann in der Tiefe, wie auch im relativen Abstand zu dem tiefen p-dotierten Halbleiterbereich DP variieren. Verringert sich dieser Abstand DP-HN in dem Avalanche-Bereich AB, oder invertiert sich die Tiefenfolge von DP und HN in diesem Bereich, so wird hier die durch diese n-Implantation HN bewirkte Barriere zur Sammlung von Signalelektroden abgebaut. Dieser Effekt kann dazu verwendet werden, Signalelektronen in das Zentrum des Avalanche-Bereichs AB zu fokussieren.

Die Erfindung ist nicht auf die vorstehend dargestellten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen.

## Patentansprüche

1. Avalanche-Strahlungsdetektor, mit
a) einem Halbleitersubstrat (HK) mit einer Vorderseite (VS) und einer Rückseite (RS),
b) einem Avalanche-Bereich (AB), der in dem Halbleitersubstrat (HK) an der Vorderseite (VS) des Halbleitersubstrats (HK) angeordnet ist,
c) einer Steuerelektrode (R) zur Einstellung der elektrischen Feldstärke in dem Avalanche-Bereich (AB), wobei die Steuerelektrode (R) ebenfalls an der Vorderseite des Halbleitersubstrats (HK) angeordnet ist,
d) einem an der Vorderseite (VS) angeordneten Auslesekontakt (A) sowie
e) einem an der Rückseite (RS) des Halbleitersubstrats (HK) angeordneten Strahlungseintrittsfenster für die zu detektierende Strahlung,
**dadurch gekennzeichnet,**
f) **dass** der Avalanche-Bereich (AB) einen in dem Halbleitersubstrat (HK) vergrabenen und entsprechend einem ersten Dotierungstyp (p) dotierten Halbleiterbereich (DP) aufweist, wobei der vergrabene Halbleiterbereich (DP) von der Steuerelektrode (R) steuerbar ist,
g) **dass** der vergrabene Halbleiterbereich (DP) direkt mit der Steuerelektrode (R) verbunden ist.

2. Avalanche-Strahlungsdetektor nach Anspruch 1, **dadurch gekennzeichnet, dass** die Steuerelektrode (R) den Avalanche-Bereich (AB) ringförmig umgibt.

3. Avalanche-Strahlungsdetektor nach einem der vorhergehenden Ansprüche, **gekennzeichnet durch** ein elektrisches Driftfeld in dem Halbleitersubstrat (HK), das **durch** die Strahlung generierte Ladungsträger innerhalb des Halbleitersubstrats (HK) zu dem Avalanche-Bereich (AB) bewegt.

4. Avalanche-Strahlungsdetektor nach einem der vorhergehenden Ansprüche, **dadurch gekennzeichnet, dass** die Steuerelektrode (R) entsprechend einem ersten Dotierungstyp (p) dotiert ist, während das Halbleitersubstrat (HK) entsprechend einem entgegengesetzten zweiten Dotierungstyp (n) dotiert ist.

5. Avalanche-Strahlungsdetektor nach einem der vorhergehenden Ansprüche, **dadurch gekennzeichnet, dass** das Strahlungseintrittsfenster wesentlich großflächiger als der Avalanche-Bereich (AB) ist.

6. Avalanche-Strahlungsdetektor nach einem der vorhergehenden Ansprüche, **dadurch gekennzeichnet, dass** sich in dem Halbleitersubstrat (HK) ein photosensitiver Bereich befindet, in dem von der zu detektierenden Strahlung Ladungsträger generiert werden, wobei der photosensitive Bereich wesentlich großflächiger und/oder großvolumiger und/oder dicker und/oder breiter als der Avalanche-Bereich (AB) ist.

7. Avalanche-Strahlungsdetektor nach einem der vorhergehehenden Ansprüche, **dadurch gekennzeichnet, dass** die Dotierung des vergrabenen Halbleiterbereichs (DP) in lateraler Richtung hinsichtlich der Dotierungsstärke und/oder hinsichtlich der Tiefenausdehnung variiert.

8. Avalanche-Strahlungsdetektor nach einem der vorhergehenden Ansprüche, **dadurch gekennzeichnet, dass** der vergrabene Halbleiterbereich (DP) in dem Avalanche-Bereich (AB) verarmt ist und außerhalb des Avalanche-Bereichs (AB) nur teilweise verarmt ist.

9. Avalanche-Strahlungsdetektor nach einem der vorhergehenden Ansprüche, **dadurch gekennzeichnet, dass** der Avalanche-Bereich (AB) einen Auslesekontakt (A) aufweist, der entsprechend dem zweiten Dotierungstyp (n) dotiert ist.

10. Avalanche-Strahlungsdetektor nach Anspruch 9, **dadurch gekennzeichnet, dass** der Auslesekontakt (A) in einen niedriger dotierten Halbleiterbereich desselben Dotierungstyps (n) eingebettet ist.

11. Avalanche-Strahlungsdetektor nach Anspruch 9 oder 10, **dadurch gekennzeichnet, dass** die Dotierung des Auslesekontakts (A) und/oder des Halbleiterbereichs, in den der Auslesekontakt (A) eingebettet ist, in lateraler Richtung hinsichtlich der Dotierungsstärke und/oder hinsichtlich der Tiefenausdehnung variiert.

12. Avalanche-Strahlungsdetektor nach einem der vorhergehenden Ansprüche, **dadurch gekennzeichnet, dass** sich der Auslesekontakt (A) oder der Halbleiterbereich, in den der Auslesekontakt (A) eingebettet ist, einerseits und der vergrabene Halbleiterbereich (DP) andererseits in lateraler Richtung teilweise überlappen, wobei sich deren gegenteilige Dotierung mindestens teilweise kompensiert.

13. Avalanche-Strahlungsdetektor nach einem der vorhergehenden Ansprüche, **dadurch gekennzeichnet, dass** sich der vergrabene Halbleiterbereich (DP) in dem Halbleitersubstrat (HK) bis unter die Steuerelektrode (R) erstreckt.

14. Avalanche-Strahlungsdetektor, nach einem der vorhergehenden Ansprüche, **dadurch gekennzeichnet, dass** an der Rückseite (RS) des Halbleitersubstrats (HK) eine Rückelektrode (RK) angeordnet ist, um das Halbleitersubstrat (HK) zu verarmen, wobei die Rückelektrode (RK) entsprechend dem ersten Dotierungstyp (p) dotiert ist.

15. Avalanche-Strahlungsdetektor nach einem der vorhergehenden Ansprüche, **dadurch gekennzeichnet, dass** der Avalanche-Bereich (AB) von mehreren Sammelelektroden (R1-R3) umgeben ist, die in dem Halbleitersubstrat (HK) ein Driftfeld erzeugen, das auf den Avalanche-Bereich (AB) gerichtet ist.

16. Avalanche-Strahlungsdetektor nach einem der vorhergehenden Ansprüche, **dadurch gekennzeichnet, dass** die Sammelelektroden (R1-R3) den Avalanche-Bereich (AB) ringförmig und im Wesentlichen konzentrisch umgeben.

17. Avalanche-Strahlungsdetektor nach einem der vorhergehenden Ansprüche, **dadurch gekennzeichnet, dass** das Halbleitersubstrat (HK) und der vergrabene Halbleiterbereich (DP) vollständig von Ladungsträgern verarmt sind.

18. Avalanche-Strahlungsdetektor nach einem der vorhergehenden Ansprüche, **dadurch gekennzeichnet, dass** in dem Halbleitersubstrat (HK) ein elektrisches Feld mit einer Potentialbarriere besteht, wobei die Potentialbarriere eine Emission von Löchern aus der Steuerelektrode (R) und/oder aus der Rückelektrode (RK) zu der jeweils gegenüber liegenden Seite des Halbleitersubstrats (HK) verhindert.

19. Avalanche-Strahlungsdetektor nach Anspruch 18, **dadurch gekennzeichnet, dass** die Steuerelektrode (R) und die Rückelektrode (RK) gegenüber dem Auslesekontakt (A) elektrisch negativ vorgespannt sind, um die Potentialbarriere zu erzeugen.

20. Avalanche-Strahlungsdetektor nach Anspruch 18 oder 19, **dadurch gekennzeichnet, dass** zwischen der Steuerelektrode (R) und der Rückelektrode (RK) ein Potentialunterschied besteht, der so gering ist, dass sich die Potentialbarriere zwischen der Steuerelektrode (R) und der Rückelektrode (RK) befindet.

21. Avalanche-Strahlungsdetektor nach einem der vorhergehenden Ansprüche, **dadurch gekennzeichnet, dass** das Halbleitersubstrat (HK) wesentlich schwächer dotiert ist als der vergrabene Halbleiterbereich (DP), der Auslesekontakt (A), die Rückelektrode (RK) und/oder die Steuerelektrode (R).

22. Avalanche-Strahlungsdetektor nach einem der vorhergehenden Ansprüche, **dadurch gekennzeichnet, dass** das Halbleitersubstrat (HK), der vergrabene Halbleiterbereich (DP), der Auslesekontakt (A), die Rückelektrode (RK) und/oder die Steuerelektrode (R) mindestens teilweise aus Silizium oder Germanium besteht.

23. Avalanche-Strahlungsdetektor nach einem der vorhergehenden Ansprüche, **dadurch gekennzeichnet, dass** der erste Dotierungstyp (p) einer p-Dotierung entspricht, während der zweite Dotierungstyp (n) einer n-Dotierung entspricht.

24. Avalanche-Strahlungsdetektor nach einem der Ansprüche 1 bis 23, **dadurch gekennzeichnet, dass** der erste Dotierungstyp einer n-Dotierung entspricht, während der zweite Dotierungstyp einer p-Dotierung entspricht.

25. Detektoranordnung mit mehreren Avalanche-Strahlungsdetektoren nach einem der vorhergehenden Ansprüche, wobei die Avalanche-Strahlungsdetektoren matrixförmig angeordnet sind.

## Claims

1. An avalanche radiation detector comprising
a) a semiconductor substrate (HK) with a front side (VS) and a back side (RS),
b) an avalanche region (AB) which is arranged in the semiconductor substrate (HK) on the front side (VS) of the semiconductor substrate (HK),
c) a control electrode (R) for adjusting the electric field strength in the avalanche region (AB), wherein the control electrode (R) is also arranged on the front side (VS) of the semiconductor substrate (HK),
d) a read-out contact (A) arranged on the front side (VS)
and
e) a radiation inlet window for the radiation to be detected, arranged on the back side (RS) of the semiconductor substrate (HK),
**characterised in that**
f) the avalanche region (AB) comprises a semiconductor region (DP) buried in the semiconductor substrate (HK) and doped according to a first doping type (p), wherein the buried semiconductor region (DP) can be controlled by the control electrode (R),
g) the buried semiconductor region (DP) is directly connected with the control electrode (R).

2. The avalanche radiation detector according to claim 1, **characterised in that** the control electrode (R) surrounds the avalanche region (AB) in a ring shape.

3. The avalanche radiation detector according to one of the preceding claims, **characterised by** an electric drift field in the semiconductor substrate (HK) which moves the radiation-generated charge carriers inside the semiconductor substrate (HK) to the avalanche region (AB).

4. The avalanche radiation detector according to one of the preceding claims, **characterised in that** the control electrode (R) is doped according to a first type of doping (p) whereas the semiconductor substrate (HK) is doped according to an opposite second type of doping (n).

5. The avalanche radiation detector according to one of the preceding claims, **characterised in that** the radiation inlet window has a substantially larger area than the avalanche region (AB).

6. The avalanche radiation detector according to one of the preceding claims, **characterised in that** a photosensitive region is located in the semiconductor substrate (HK) wherein charge carriers are generated by the radiation to be detected, wherein the photosensitive region has a substantially larger area and/or larger volume and/or is thicker and/or is broader than the avalanche region (AB).

7. The avalanche radiation detector according to one of the preceding claims, **characterised in that** the doping of the buried semiconductor region (DP) varies in the lateral direction with regard to the doping strength and/or with regard to the depth extension.

8. The avalanche radiation detector according to one of the preceding claims, **characterised in that** the buried semiconductor (DP) is depleted in the avalanche region (AB) and is only partially depleted outside the avalanche region (AB).

9. The avalanche radiation detector according to one of the preceding claims, **characterised in that** the avalanche region (AB) has a read-out contact (A) which is doped according to the second type of doping (n).

10. The avalanche radiation detector according to claim 9, **characterised in that** the read-out contact (A) is embedded in a lower doped semiconductor region of the same doping type (n).

11. The avalanche radiation detector according to claim 9 or 10, **characterised in that** the doping of the read-out contact (A) and/or the semiconductor region in which the read-out contact (A) is embedded, varies in the lateral direction with regard to the doping strength and/or with regard to the depth extension.

12. The avalanche radiation detector according to one of the preceding claims, **characterised in that** the read-out contact (A) or the semiconductor region in which the read-out contact (A) is embedded on the one hand and the buried semiconductor region (DP) on the other hand partially overlap in the lateral direction, wherein their opposite doping is at least partly compensated.

13. The avalanche radiation detector according to one of the preceding claims, **characterised in that** the buried semiconductor region (DP) in the semiconductor substrate (HK) extends as far as below the control electrode (R).

14. The avalanche radiation detector according to one of the preceding claims, **characterised in that** a rear electrode (RK) is arranged on the back side (RS) of the semiconductor substrate (HK) to deplete the semiconductor substrate (HK) wherein the rear electrode (RK) is doped according to the first doping type (p).

15. The avalanche radiation detector according to one of the preceding claims, **characterised in that** the avalanche region (AB) is surrounded by a plurality of collector electrodes (R1-R3) which generate a drift field in the semiconductor substrate (HK), which is directed onto the avalanche region (AB).

16. The avalanche radiation detector according to one of the preceding claims, **characterised in that** the collector electrodes (R1-R3) surround the avalanche region (AB) in a ring shape and substantially concentrically.

17. The avalanche radiation detector according to one of the preceding claims, **characterised in that** the semiconductor substrate (HK) and the buried semiconductor region (DP) are completely depleted in charge carriers.

18. The avalanche radiation detector according to one of the preceding claims, **characterised in that** an electric field with a potential barrier exists in the semiconductor substrate (HK), wherein the potential barrier prevents any emission of holes from the control electrode (R) and/or from the rear electrode (RK) to the respectively opposing side of the semiconductor substrate (HK).

19. The avalanche radiation detector according to claim 18, **characterised in that** the control electrode (R) and the rear electrode (RK) are at a negative electric potential with respect to the read-out contact (A) to produce the potential barrier.

20. The avalanche radiation detector according to claim 18 or 19, **characterised in that** a potential difference exists between the control electrode (R) and the rear electrode (RK) which is so small that the potential barrier is located between the control electrode (R) and the rear electrode (RK).

21. The avalanche radiation detector according to one of the preceding claims, **characterised in that** the semiconductor substrate (HK) is substantially more weakly doped than the buried semiconductor region (DP), the read-out contact (A), the rear electrode (RK) and/or the control electrode (R).

22. The avalanche radiation detector according to one of the preceding claims, **characterised in that** the semiconductor substrate (HK), the buried semiconductor region (DP), the read-out contact (A), the rear electrode (RK) and/or the control electrode (R) consists at least partly of silicon or germanium.

23. The avalanche radiation detector according to one of the preceding claims, **characterised in that** the first doping type (p) corresponds to p-doping whereas the second doping type (n) corresponds to n-doping.

24. The avalanche radiation detector according to one of claims 1 to 23, **characterised in that** the first doping type corresponds to n-doping whereas the second doping type corresponds to p-doping.

25. A detector arrangement comprising a plurality of avalanche radiation detectors according to any one of the preceding claims, wherein the avalanche radiation detectors are arranged in a matrix form.

## Revendications

1. Photodétecteur à avalanche, comportant
a) un substrat semi-conducteur (HK) avec une face avant (VS) et une face arrière (RS),
b) une zone à avalanche (AB), disposée dans le substrat semi-conducteur (HK) sur la face avant (VS) dudit substrat semi-conducteur (HK),
c) une électrode de commande (R) pour le réglage de l'intensité de champ électrique dans la zone à avalanche (AB), ladite électrode de commande (R) étant également disposée sur la face avant du substrat semi-conducteur (HK),
d) un contact de lecture (A) disposé sur la face avant (VS), ainsi
e) qu'une fenêtre d'entrée de radiation pour la radiation à détecter, disposée sur la face arrière (RS) du substrat semi-conducteur (HK),
**caractérisé**
f) **en ce que** la zone à avalanche (AB) comporte une zone semi-conductrice (DP) noyée dans le substrat semi-conducteur (HK) et dopée suivant un premier type de dopage (p), ladite zone semi-conductrice noyée (DP) pouvant être commandée par l'électrode de commande (R),
g) **en ce que** la zone semi-conductrice noyée (DP) est directement reliée à l'électrode de commande (R).

2. Photodétecteur à avalanche selon la revendication 1, **caractérisé en ce que** l'électrode de commande (R) entoure annulairement la zone à avalanche (AB).

3. Photodétecteur à avalanche selon l'une des revendications précédentes, **caractérisé par** un champ électrique de glissement dans le substrat semi-conducteur (HK), lequel déplace le porteur de charge généré par la radiation vers la zone à avalanche (AB) à l'intérieur du substrat semi-conducteur (HK).

4. Photodétecteur à avalanche selon l'une des revendications précédentes, **caractérisé en ce que** l'électrode de commande (R) est dopée suivant un premier type de dopage (p), tandis que le substrat semi-conducteur (HK) est dopé suivant un deuxième type de dopage opposé (n).

5. Photodétecteur à avalanche selon l'une des revendications précédentes, **caractérisé en ce que** la fenêtre d'entrée de radiation est de surface sensiblement supérieure à la zone à avalanche (AB).

6. Photodétecteur à avalanche selon l'une des revendications précédentes, **caractérisé en ce qu'**une zone photosensible se trouve dans le substrat semi-conducteur (HK), où des porteurs de charge sont générés par la radiation à détecter, ladite zone photosensible étant de surface et/ou de volume et/ou d'épaisseur et/ou de largeur sensiblement supérieurs à la zone à avalanche (AB).

7. Photodétecteur à avalanche selon l'une des revendications précédentes, **caractérisé en ce que** le dopage de zone semi-conductrice noyée (DP) varie en direction latérale quant à l'intensité du dopage et/ou quant à l'extension en profondeur.

8. Photodétecteur à avalanche selon l'une des revendications précédentes, **caractérisé en ce que** la zone semi-conductrice noyée (DP) est appauvrie dans la zone à avalanche (AB), et n'est que partiellement appauvrie à l'extérieur de la zone à avalanches (AB).

9. Photodétecteur à avalanche selon l'une des revendications précédentes, **caractérisé en ce que** la zone à avalanches (AB) comporte un contact de lecture (A), lequel est dopé suivant le deuxième type de dopage (n).

10. Photodétecteur à avalanche selon la revendication 9, **caractérisé en ce que** le contact de lecture (A) est logé dans une zone semi-conductrice plus faiblement dopée du même type de dopage (n).

11. Photodétecteur à avalanche selon la revendication 9 ou la revendication 10, **caractérisé en ce que** le dopage du contact de lecture (A) et/ou de la zone semi-conductrice où est logé le contact de lecture (A) varie en direction latérale quant à l'intensité du dopage et/ou quant à l'extension en profondeur.

12. Photodétecteur à avalanche selon l'une des revendications précédentes, **caractérisé en ce que** le contact de lecture (A) ou la zone semi-conductrice où est logé le contact de lecture (A), d'une part, et la zone semi-conductrice noyée (DP), d'autre part, se chevauchent partiellement en direction latérale, leurs dopages contraires se compensant au moins partiellement.

13. Photodétecteur à avalanche selon l'une des revendications précédentes, **caractérisé en ce que** la zone semi-conductrice noyée (DP) s'étend dans le substrat semi-conducteur (HK) jusque sous l'électrode de commande (R).

14. Photodétecteur à avalanche selon l'une des revendications précédentes, **caractérisé en ce qu'**une électrode arrière (RK) est disposée sur la face arrière (RS) du substrat semi-conducteur (HK) pour appauvrir le substrat semi-conducteur (HK), ladite électrode arrière (RK) étant dopée suivant le premier type de dopage (p).

15. Photodétecteur à avalanche selon l'une des revendications précédentes, **caractérisé en ce que** la zone à avalanche (AB) est entourée par plusieurs électrodes collectrices (R1-R3) qui génèrent un champ de glissement dans le substrat semi-conducteur (HK), lequel est orienté vers la zone à avalanche (AB).

16. Photodétecteur à avalanche selon l'une des revendications précédentes, **caractérisé en ce que** les électrodes collectrices (R1-R3) entourent annulairement et sensiblement concentriquement la zone à avalanche (AB).

17. Photodétecteur à avalanche selon l'une des revendications précédentes, **caractérisé en ce que** le substrat semi-conducteur (HK) et la zone semi-conductrice noyée (DP) sont entièrement appauvris par des porteurs de charge.

18. Photodétecteur à avalanche selon l'une des revendications précédentes, **caractérisé en ce qu'**un champ électrique avec une barrière de potentiel est présenté dans le substrat semi-conducteur (HK), ladite barrière de potentiel empêchant une émission de trous depuis l'électrode de commande (R) et/ou depuis l'électrode arrière (RK) vers le côté respectivement opposé du substrat semi-conducteur (HK).

19. Photodétecteur à avalanche selon la revendication 18, **caractérisé en ce que** l'électrode de commande (R) et l'électrode arrière (RK) sont à polarisation électrique négative par rapport au contact de lecture (A), pour générer la barrière de potentiel.

20. Photodétecteur à avalanche selon la revendication 18 ou 19, **caractérisé en ce qu'**une différence de potentiel est présentée entre l'électrode de commande (R) et l'électrode arrière (RK), laquelle est si réduite que la barrière de potentiel se trouve entre l'électrode de commande (R) et l'électrode arrière (RK).

21. Photodétecteur à avalanche selon l'une des revendications précédentes, **caractérisé en ce que** le substrat semi-conducteur (HK) est sensiblement plus faiblement dopé que la zone semi-conductrice (DP), le contact de lecture (A), l'électrode arrière (RK) et/ou l'électrode de commande (R).

22. Photodétecteur à avalanche selon l'une des revendications précédentes, **caractérisé en ce que** le substrat semi-conducteur (HK), la zone semi-conductrice noyée (DP), le contact de lecture (A), l'électrode arrière (RK) et/ou l'électrode de commande (R) sont au moins partiellement en silicium ou en germanium.

23. Photodétecteur à avalanche selon l'une des revendications précédentes, **caractérisé en ce que** le premier type de dopage (p) correspond à un dopage p, alors que le deuxième type de dopage (n) correspond à un dopage n.

24. Photodétecteur à avalanche selon l'une des revendications 1 à 23, **caractérisé en ce que** le premier type de dopage correspond à un dopage n, alors que le deuxième type de dopage correspond à un dopage p.

25. Agencement de détecteurs avec plusieurs photodétecteurs à avalanche selon l'une des revendications précédentes, où les photodétecteurs à avalanche sont agencés en forme de matrice.
